# EUROPÄISCHE PATENTSCHRIFT

(11) **EP 2 720 320 B1**
(45) Veröffentlichungstag und Bekanntmachung des Hinweises auf die Patenterteilung: **31.08.2016**
(21) Anmeldenummer: 12188362.3
(22) Anmeldetag: 12.10.2012
(51) Int. Cl.: H01M 2/20, H01M 10/48, H01R 4/24, G01R 31/36

(54) **Zellverbinder für ein Batteriesystem**
Cell connector for a battery system
Connecteur de cellules pour un système de batterie

(43) Veröffentlichungstag der Anmeldung: 16.04.2014
(73) Patentinhaber: Samsung SDI Co., Ltd., Yongin-si, Gyeonggi-do (KR)
(72) Erfinder: Fauland, David, 8522 Groß St. Florian (AT)
(74) Vertreter: Gulde & Partner

(56) Entgegenhaltungen:
- DE-A1-102010 030 809
- JP-A- 2002 151 045
- US-A1- 2011 045 329
- US-A1- 2011 081 568
- US-A1- 2011 117 769
- US-A1- 2012 015 550

## Beschreibung

### Gebiet der Erfindung

Die vorliegende Erfindung betrifft einen Zellverbinder für ein Batteriesystem das mehrere Batteriezellen umfasst, wobei durch den Zellverbinder ein Pol einer Batteriezelle mit einem Pol einer angrenzenden Batteriezelle verbindbar ist, wobei an dem Zellverbinder zum Abgriff der elektrischen Spannung eine Schneidklemme angebracht ist, wobei der Zellverbinder einen ersten Abschnitt aufweist der aus einem ersten Werkstoff besteht, und einen zweiten Abschnitt aufweist, der aus einem zweiten, zum ersten Werkstoff unterschiedlichen Werkstoff besteht, wobei der erste Abschnitt und der zweite Abschnitt stoffschlüssig miteinander verbunden sind.
Die Erfindung betrifft weiters ein Batteriesystem mit einem erfindungsgemäßen Zellverbinder.

### Stand der Technik

Derartige Vorrichtungen werden zum Verbinden von Polen benachbarter Batteriezellen verwendet. Die Batteriezellen sind dabei beispielsweise so angeordnet, dass ein positiver Pol und ein negativer Pol einer angrenzenden Batteriezelle einander gegenüberliegend angeordnet sind.

Die Zellverbinder dienen in erster Linie zum elektrischen Verbinden der Batteriezellen. Durch ihre Lage eignen sie sich zum Befestigen von Zellspannungsabgriffen. An den Zellspannungsabgriffen können Mess-Leitungen befestigt werden, die in weiterer Folge zu einer Elektronikeinheit führen. Die Elektronikeinheit dient zur Überwachung der Batteriezellen und erfasst beispielsweise den Ladezustand oder auch die Temperatur der einzelnen Batteriezellen.

Die Pole der Batteriezellen sind beispielsweise aus Aluminium bzw. einer Aluminiumlegierung hergestellt. Die Pole können aber auch aus einem anderen Werkstoff hergestellt sein, wie beispielsweise Kupfer oder Stahl. Es sind auch Mischbauformen, mit einem Pol aus Kupfer und einem Pol aus Aluminium im Stand der Technik bekannt. Die Mess-Leitungen werden aus Kosten- und Herstellungsgründen aus Kupfer gefertigt und sind mit einer elektrisch isolierenden Schicht überzogen.

Die US 2012/015550 A1 offenbart einen Zellverbinder mit einer Schneidklemme. Die Schneidklemme ist entweder einstückig am Zellverbinder ausgebildet oder lose im Bereich des Anschlussterminals auf den Zellverbinder gelegt.

Aus der DE102009033044A1 ist eine Stromzuführeinheit bekannt, welche eine Vielzahl von Sammelschienen, die jeweils ein Paar von Verbindungsteilen, die jeweils mit den angrenzenden Elektroden der angrenzenden Batterien verbunden sind, sowie einen Kopplungsteil aufweisen, der die paarigen Verbindungsteile miteinander koppelt, einen Vielzahl von Klemmelementen, mit denen die Elektroden und die Verbindungsteile festgeklemmt werden, um die Elektroden elektrisch mit den Verbindungsteilen zu verbinden, und eine Platte enthält, an der die Sammelschienen und die Klemmelemente angebracht sind.

Nachteilig bei dieser Ausführung ist der aufwendige und oft große Aufbau der Klemmenelemente, welche durch Klemmen oder Aufpressen mit den Elektroden von Batteriezellen verbunden werden, wobei die elektrischen Drähte integral mit den Klemmelementen verbunden sind.

Es ist eine Aufgabe der Erfindung einen verbesserten Zellverbinder und ein verbessertes Batteriesystem anzugeben, die eine vereinfachte Befestigung von Mess-Leitung ermöglichen.

### Zusammenfassung der Erfindung

Die Lösung der Aufgabe erfolgt durch einen Zellverbinder für ein Batteriesystem das mehrere Batteriezellen umfasst, wobei durch den Zellverbinder ein Pol einer Batteriezelle mit einem Pol einer angrenzenden Batteriezelle verbindbar ist, wobei an dem Zellverbinder zum Abgriff der elektrischen Spannung eine Schneidklemme angebracht ist, wobei der Zellverbinder einen ersten Abschnitt aufweist der aus einem ersten Werkstoff besteht, aus Aluminium bzw. Aluminiumlegierung, und einen zweiten Abschnitt aufweist, der aus einem zweiten, zum ersten Werkstoff unterschiedlichen Werkstoff besteht, nämlich aus Kupfer, wobei der erste Abschnitt und der zweite Abschnitt stoffschlüssig miteinander verbunden sind, wobei die Schneidklemme mit dem zweiten Abschnitt des Zellverbinders elektrisch leitend verbunden ist, wobei die Schneidklemme mit dem zweiten Abschnitt des Zellverbinders dauerhaft verbunden ist.

Dadurch ist es möglich, eine relativ kleine Klemmverbindung herzustellen, wodurch Kosten und Gewicht, bei geringerem Bauraum, reduziert werden können. Es wird weiters eine bessere elektrisch leitende Verbindung zwischen den Polen der Zellen und der Messleitung ermöglicht. Ein weiterer Vorteil ist, dass die Mess-Leitungen lösbar mit den Zellverbindern verbunden sind.

Der Vorteil bei der Verwendung von Schneidklemmen ist, dass die Adern einer Mess-Leitung mit Hilfe eines speziellen Werkzeugs in die Schneidklemmen gepresst werden können, ohne die Messleitung zuvor Abisolieren zu müssen. Aufgrund scharfer Kontakte in der metallischen Schneidklemme wird die Isolierung der Ader durchtrennt und eine gasdichte Verbindung hergestellt. Da es sich um eine löt-, schraub- und abisolierfreie Verbindungstechnik handelt, wird diese Technik oft als LSA- Technik bezeichnet.
Mit Hilfe dieser Technik lassen sich eine große Anzahl von Kabeln rasch und prozesssicher elektrisch und mechanisch kontaktieren, was besonders bei einem Batteriesystem mit einer hohen Anzahl an Batteriezellen zu einer großen Zeitersparnis führt.
Um eine gute Kontaktierung der Mess-Leitung in der Schneidklemme zu gewährleisten, ist es besonders vorteilhaft, dass die Schneidklemme und die Mess-Leitung aufeinander abgestimmt sind.

Weiterbildungen der Erfindung sind in den abhängigen Ansprüchen, der Beschreibung sowie den beigefügten Zeichnungen angegeben.

In einer erfinderischen Ausgestaltung erfolgt die Verbindung der Schneidklemme auf den zweiten Abschnitt des Zellverbinders durch beispielsweise Löten oder Ultraschallschweißen. Diese Technologien sind dem Fachmann hinlänglich bekannt und werden daher nicht beschrieben.

Alternativ kann die Schneidklemme durch Einpressen in den zweiten Abschnitt des Zellverbinders mit diesem verbunden werden. Hierbei weist die Schneidklemme zumindest einen Fortsatz auf, welcher in zumindest eine entsprechend vorgefertigte Bohrung des zweiten Abschnitts des Zellverbinders eingepresst wird.

Ein weiteres Verfahren ist das sogenannte "Schießen". Es handelt sich hierbei um eine Direktmontage, welche es als ein- oder mehrstufiges Befestigungsverfahren gibt. Beim einstufigen Verfahren wird ein Fortsatz der Schneidklemme ohne weitere Vorarbeiten (z.B. Bohren) direkt in den Zellverbinder eingetrieben. Dabei ist es von Vorteil, wenn die Schneidklemme, zumindest jedoch der Fortsatz, aus einem härteren Werkstoff als der Zellverbinder ausgebildet ist. Die Schneidklemme könnte beispielsweise einen spitzen Zapfen als Fortsatz aufweisen welcher beim "Schießen" durch den Zellverbinder getrieben wird.
Beim mehrstufigen Verfahren wird im Zellverbinder eine Bohrung mit geringer Tiefe erstellt. In diese Bohrung wird die Schneidklemme, wie beim einstufigen Verfahren, eingetrieben.
Beim Schießen handelt es sich um eine stoffschlüssige Kaltverformungskontaktierung.

Da beim Schießen und Einpressen die Schneidklemme zumindest einen Fortsatz aufweisen kann, welcher nach der Verbindung der Schneidklemme mit dem Zellverbinder durch diesen ragen kann, ist, bei der Verbindung des Zellverbinders mit einem Polanschluss einer Batteriezelle, darauf zu achten, dass eine ausreichend großer Abstand zwischen dem Fortsatz der Schneidklemme und der Oberfläche der Batteriezelle vorhanden ist, um eine Beschädigung der Oberfläche der Batteriezelle zu vermeiden bzw. eine ausreichend große elektrische Luft- / Kriech-Strecke zwischen den Bauteilen zu erreichen.
Dies kann durch eine entsprechende Höhe des Polanschlusses oder eine entsprechende geometrische Ausbildung des Zellverbinders erreicht werden.

Es kann natürlich im Rahmen der Erfindung jedes weitere dem Fachmann bekannte Verbindungsverfahren, zur geeigneten Verbindung der Schneidklemme mit dem zweiten Abschnitt des Zellverbinders, beispielsweise Kleben, angewendet werden.
Die Verbindungsverfahren zur Herstellung der Verbindung der Schneidklemme mit dem Zellverbinder sind für den jeweiligen Anwendungsfall so angepasst, dass eine automatisierte Fertigung möglich ist.

Vorzugsweise besteht ein erster Abschnitt des Zellverbinders aus dem gleichen Material wie die Pole der Batteriezellen, beispielsweise kann dies Aluminium bzw. eine Aluminiumlegierung sein.

In einer weiteren bevorzugten Ausführungsform, besteht ein zweiter Abschnitt des Zellverbinders aus dem gleichen Werkstoff wie die Mess-Leitung, bevorzugt kann dies Kupfer sein.

Wenn der zweite Abschnitt des Zellverbinders den gleichen Werkstoff wie die Mess-Leitung aufweist wird aufgrund des gleichen Standardpotentials in der elektrochemische Spannungsreihe, eine Korrosion zwischen diesen Bauteilen verhindert.

Gemäß einer weiteren Ausgestaltung der Erfindung wird der zweite Abschnitt mit dem ersten Abschnitt durch Plattieren, insbesondere Walzplattieren, verbunden. Dabei wird ein Blech unter Druck und Wärme auf das Grundmaterial aufgewalzt. Es entsteht dabei eine unlösbare Verbindung durch Diffusion und Pressschweißung. Vielfach werden mit diesen Verfahren korrosionsbeständige Bleche erzeugt.
Man unterscheidet hierbei im wesentlichen drei Varianten:
- Overlaybeschichtung: hier erhält das Trägerband auf einer oder beider Seiten vollflächige Belege,
- Inlaybeschichtung: hierbei werden streifenförmige Einlageplattierungen aus Unedel- oder Edelmetallen im Trägerwerkstoff ein- oder beidseitig eingebettet,
- Onlaybeschichtung: hier werden dünne streifenförmige Kontaktwerkstoffe ein- oder beidseitig direkt aufplattiert.

Alternativ kann auch Ultraschall-Schweißen zum Verbinden der beiden Abschnitte des Zellverbinders angewendet werden.

Gemäß einer Ausführungsform der Erfindung kann eine Mess-Leitung in die Schneidklemme eingeführt werden.
Die Einführung der Mess-Leitung in die Schneidklemme kann hierbei vorzugsweise automatisiert erfolgen, wodurch eine schnelle, sichere und kostengünstige Montage realisiert werden kann.

Die Mess-Leitung ist zumindest Abschnittsweise mit einer Isolationsschicht überzogen, um ungewollten Kontakt mit anderen elektrisch leitenden Bauteilen zu vermeiden.

In einer weiteren Ausführungsform ist die Mess-Leitung mit einer Elektronikeinheit mittels Schneidklemme oder Crimp verbunden. Die Schneidklemme kann hierbei auf der Mess-Leitung oder der Elektronikeinheit vorgesehen werden.

### Kurzbeschreibung der Zeichnungen

Die Erfindung wird im Folgenden beispielhaft unter Bezugnahme auf die Zeichnungen beschrieben.
- Fig. 1: zeigt eine Draufsicht eines Batteriesystems aus mehreren Zellen bestehend, mit erfindungsgemäßen Zellverbindern.
- Fig. 2: zeigt eine Detailansicht gemäß Fig. 1 von oben.
- Fig. 3: zeigt den Zellverbinder in Draufsicht und Seitenansicht.
- Fig. 4: zeigt eine Anordnung einer Schneidklemme auf dem Zellverbinder.
- Fig. 5,6,7: zeigen Verbindungsverfahren zur Anbringung einer Schneidklemme auf einem Zellverbinder.

### Detaillierte Beschreibung der Erfindung

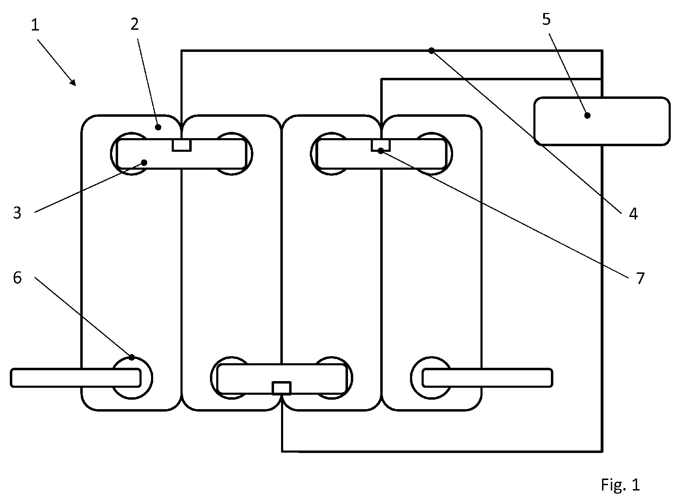

In Fig. 1 wird schematisch eine erfindungsgemäße Anordnung eines Batteriesystems 1 mit mehreren Batteriezellen 2, welche durch Zellverbinder 3 miteinander in Reihe geschalten sind, dargestellt. Die Mess-Leitungen 4, sind mit der Elektronikeinheit 5 und den Schneidklemmen 7 die an den Zellverbindern 3 angeordnet sind, elektrisch verbunden.

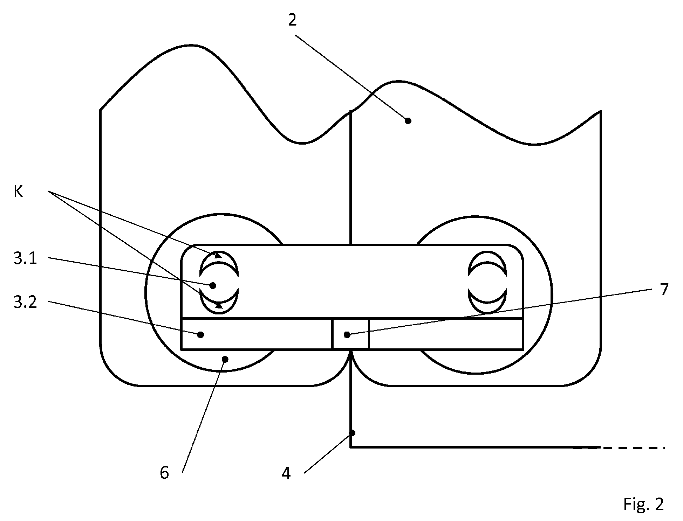

Fig. 2 zeigt schematisch eine Detailansicht von Fig. 1, wobei auf dem Zellverbinder 3, bestehend aus einem ersten Abschnitt 3.1 und einem zweiten Abschnitt 3.2, die Schneidklemme 7 schematisch dargestellt ist. Der erste Abschnitt 3.1 ist bevorzugt aus Aluminium oder eine Aluminiumlegierung. Der zweite Abschnitt 3.2 ist bevorzugt aus Kupfer. Die Mess-Leitung 4 ist mit der Schneidklemme 7 elektrisch verbunden. Der Zellverbinder 3 ist mit den Polen 6 durch die Schweißabschnitte K mittels Schweißen fest verbunden.

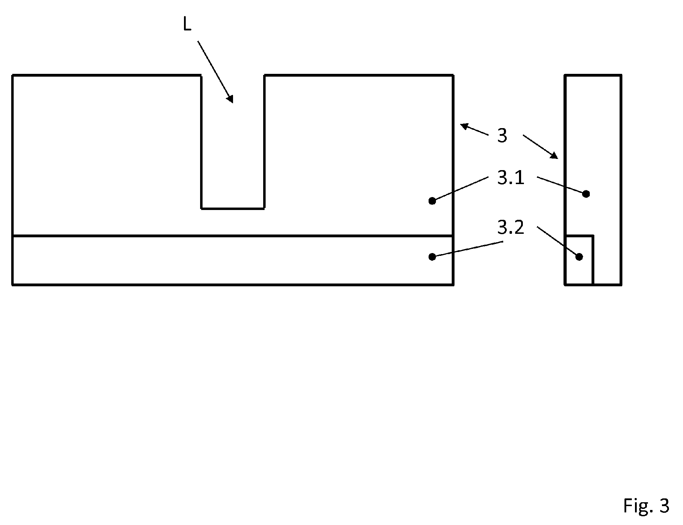

Fig. 3 zeigt in einer Drauf- und Seitenansicht die erfindungsgemäße Ausführung des Zellverbinders 3. Der erste Abschnitt 3.1 ist mit dem zweiten Abschnitt 3.2 des Zellverbinders 3 verbunden. Die Anordnung der Schneidklemme 7 wird nicht dargestellt. Der Zellverbinder 3 weist einen flexiblen Abschnitt L auf, welcher für Toleranzausgleiche erforderlich ist.

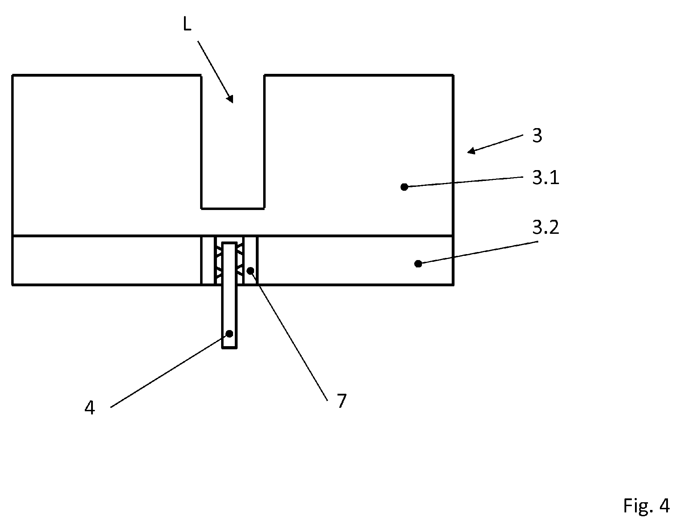

In Fig. 4 wird schematisch die Anordnung der Schneidklemme 7 mit dem Zellverbinder 3 dargestellt. Die Schneidklemme 7 ist mit dem zweiten Abschnitt 3.2 des Zellverbinders 3 verbunden. Der zweite Abschnitt 3.2 ist hierbei bevorzugt mittels Plattieren mit dem ersten Abschnitt 3.1 des Zellverbinders 3 verbunden. Es ist natürlich jede dem Fachmann bekannte Art zur Verbindung zweier Werkstoffe denkbar. Die Mess-Leitung 4 ist mit der Schneidklemme 7 verbunden, wobei die Mess-Leitung 4 mit einer nicht dargestellten Elektronikeinheit 5 verbindbar ist. Dabei wird durch die Schneidklemme die elektrische Isolationsschicht der Mess-Leitung 4 durchdrungen, wodurch eine elektrisch leitende Verbindung zwischen der Mess-Leitung und der Schneidklemme 7 hergestellt wird.

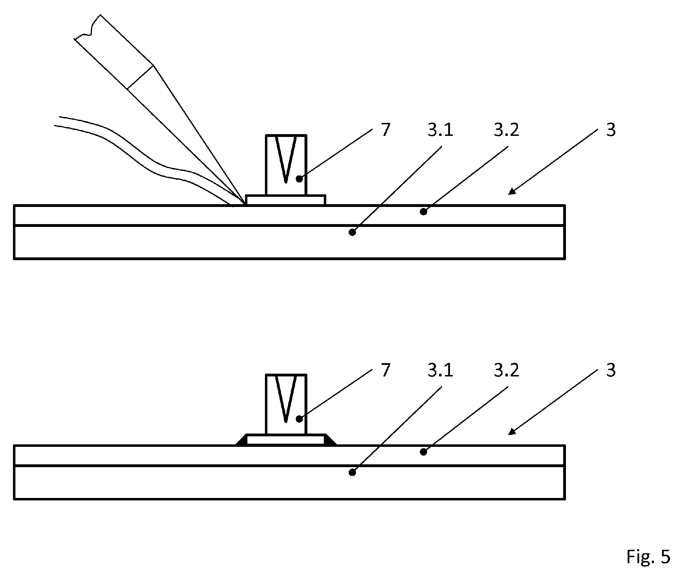

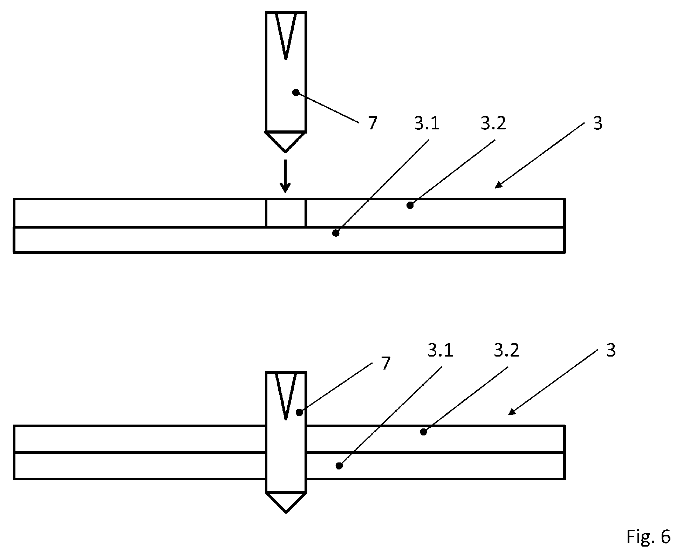

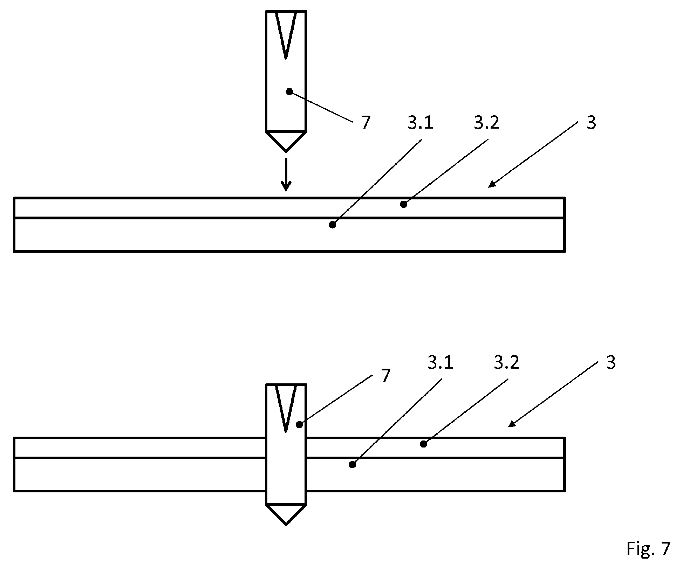

In Fig. 5 wird ein Verbindungsverfahren schematisch dargestellt. Bei diesem Verfahren wird die Schneidklemme 7 durch Löten mit dem zweiten Abschnitt 3.2 des Zellverbinders 3 verbunden. In Fig. 6 wird ein Verfahren schematisch dargestellt, bei dem die Schneidklemme 7 in den zweiten Abschnitt 3.2 des Zellverbinders 3 eingepresst wird. Die Schneidklemme 7 kann einen oder mehrere Fortsätze aufweisen, welche in den zweiten Abschnitt 3.2 des Zellverbinders 3 einpressbar sind. Fig. 7 zeigt schematisch ein Verfahren, bei dem die Schneidklemme durch sogenanntes "Schießen" mit dem Zellverbinders 3 verbunden wird. Bei diesem Verfahren ist die Schneidklemme 7 vorteilhaft aus einem härteren Werkstoff als der zweite Abschnitt 3.2 des Zellverbinders 3 ausgeführt. Der zweite Abschnitt des Zellverbinders 3 kann alternativ entsprechende Bohrungen aufweisen. Es kann natürlich auch jedes geeignetes Klebe- oder Schweißverfahren angewendet werden.

### Bezugszeichenliste

- 1: Batteriesystem
- 2: Batteriezelle
- 3: Zellverbinder
- 3.1: erster Abschnitt
- 3.2: zweiter Abschnitt
- 4: Mess-Leitung
- 5: Elektronikeinheit
- 6: Pol
- 7: Schneidklemme

- K: Schweißverbindung
- L: flexibler Abschnitt

## Patentansprüche

1. Zellverbinder (3) für ein Batteriesystem (1) das mehrere Batteriezellen (2) umfasst, wobei durch den Zellverbinder (3) ein Pol (6) einer Batteriezelle (2) mit einem Pol (6) einer angrenzenden Batteriezelle (2) verbindbar ist, wobei an dem Zellverbinder (3) zum Abgriff der elektrischen Spannung eine Schneidklemme (7) angebracht ist, **dadurch gekennzeichnet, dass** der Zellverbinder (3) einen ersten Abschnitt (3.1) aufweist der aus einem ersten Werkstoff besteht, nämlich aus Aluminium bzw. einer Aluminiumlegierung, und einen zweiten Abschnitt (3.2) aufweist, der aus einem zweiten, zum ersten Werkstoff unterschiedlichen Werkstoff besteht, nämlich aus Kupfer, wobei der erste Abschnitt (3.1) und der zweite Abschnitt (3.2) stoffschlüssig miteinander verbunden sind, wobei die Schneidklemme (7) mit dem zweiten Abschnitt (3.2) des Zellverbinders (3) elektrisch leitend verbunden ist, und wobei die Schneidklemme (7) mit dem zweiten Abschnitt (3.2) des Zellverbinders (3) dauerhaft verbunden ist.

2. Zellverbinder (3) nach Anspruch 1,
**dadurch gekennzeichnet, dass** die Schneidklemme (7) auf den zweiten Abschnitt (3.2) des Zellverbinders (3) gelötet oder mit dem zweiten Abschnitt (3.2) des Zellverbinders (3) ultraschallgeschweißt oder in den zweiten Abschnitt (3.2) des Zellverbinders (3) eingepresst oder eingeschossen ist.

3. Zellverbinder (3) nach Anspruch 1 oder 2,
**dadurch gekennzeichnet, dass** die Schneidklemme (7) zumindest einen Fortsatz aufweist, der in den Zellverbinder (3) eingeschossen ist.

4. Zellverbinder (3) nach Anspruch 1,
**dadurch gekennzeichnet, dass** der zweite Abschnitt (3.2) mit dem ersten Abschnitt (3.1) durch Plattierung, insbesondere Walzplattierung, verbunden ist.

5. Batteriesystem (1) mit mehreren Batteriezellen (2) deren Pole (6) über Zellverbinder (3) nach Anspruch 1 verbunden sind,
**dadurch gekennzeichnet, dass** in die Schneidklemmen (7) jeweils eine Mess-Leitung (4) einführbar ist.

6. Batteriesystem (1) nach Anspruch 5,
**dadurch gekennzeichnet, dass** die Mess-Leitung (4) aus Kupfer besteht und mit einer elektrischen Isolationsschicht überzogen ist.

7. Batteriesystem (1) nach Anspruch 5,
**dadurch gekennzeichnet, dass** die Mess-Leitung (4) mit einer Elektronikeinheit (5) mittels einer weiteren Schneidklemme verbindbar ist.

## Claims

1. A cell connector (3) for a battery system (1) comprising a plurality of battery cells (2), wherein a pole (6) of a battery cell (2) can be connected to a pole (6) of an adjacent battery cell (2) by the cell connector (3), wherein an insulation-piercing clamp (7) is attached to the cell connector (3) for picking up the electric voltage,
**characterised in that**
the cell connector (3) has a first portion (3.1) which consists of a first material, namely of aluminium or an aluminium alloy, and has a second portion (3.2) which consists of a second material different from the first material, namely of copper, the first portion (3.1) and the second portion (3.2) being connected together by a material bond,
wherein
the insulation-piercing clamp (7) is connected in electrically conductive manner to the second portion (3.2) of the cell connector (3), and
wherein the insulation-piercing clamp (7) is connected in permanent manner to the second portion (3.2) of the cell connector (3).

2. A cell connector (3) according to Claim 1,
**characterised in that** the insulation-piercing clamp (7) is soldered to the second portion (3.2) of the cell connector (3) or is ultrasonically welded to the second portion (3.2) of the cell connector (3) or is pressed or driven into the second portion (3.2) of the cell connector (3).

3. A cell connector (3) according to Claim 1 or 2,
**characterised in that** the insulation-piercing clamp (7) has at least one continuation which is driven into the cell connector (3).

4. A cell connector (3) according to Claim 1,
**characterised in that** the second portion (3.2) is connected to the first portion (3.1) by cladding, in particular roll cladding.

5. A battery system (1) with a plurality of battery cells (2), the poles (6) of which are connected via cell connectors (3) according to Claim 1, **characterised in that** one measuring lead (4) can be introduced into each of the insulation-piercing clamps (7).

6. A battery system (1) according to Claim 5,
**characterised in that** the measuring lead (4) consists of copper and is coated with an electrical insulating layer.

7. A battery system (1) according to Claim 5,
**characterised in that** the measuring lead (4) can be connected to an electronic unit (5) by means of a further insulation-piercing clamp.

## Revendications

1. Connecteur d'éléments (3) pour un système de batterie (1) qui comprend plusieurs éléments de batterie (2), un pôle (6) d'un élément de batterie (2) pouvant être relié à un pôle (6) d'un élément de batterie (2) adjacent au moyen du connecteur d'éléments (3), une borne guillotine (7) étant montée sur le connecteur d'éléments (3) pour prélever la tension électrique,
le connecteur d'éléments (3) étant **caractérisé en ce qu'**il comprend une première section (3.1) qui est constituée d'un premier matériau, à savoir d'aluminium ou d'un alliage d'aluminium, et une deuxième section (3.2), qui est constituée d'un deuxième matériau différent du premier matériau, à savoir de cuivre, la première section (3.1) et la deuxième section (3.2) étant reliées l'une à l'autre par liaison de matières,
la borne guillotine (7) étant reliée de manière électro-conductrice à la deuxième section (3.2) du connecteur d'éléments (3), et
la borne guillotine (7) étant reliée en permanence à la deuxième section (3.2) du connecteur d'éléments (3).

2. Connecteur d'éléments (3) selon la revendication 1,
**caractérisé en ce que** la borne guillotine (7) est brasée sur la deuxième section (3.2) du connecteur d'éléments (3) ou soudée par ultrasons à la deuxième section (3.2) du connecteur d'éléments (3) ou pressée ou enfoncée dans la deuxième section (3.2) du connecteur d'éléments (3).

3. Connecteur d'éléments (3) selon la revendication 1 ou 2,
**caractérisé en ce que** la borne guillotine (7) présente au moins un prolongement qui est enfoncé dans le connecteur d'éléments (3).

4. Connecteur d'éléments (3) selon la revendication 1,
**caractérisé en ce que** la deuxième section (3.2) est reliée à la première section (3.1) par placage, en particulier par placage par laminage.

5. Système de batterie (1) comprenant plusieurs éléments de batterie (2) dont les pôles (6) sont reliés par l'intermédiaire de connecteurs d'éléments (3) selon la revendication 1,
**caractérisé en ce que**, respectivement, une ligne de mesure (4) peut être introduite dans les bornes guillotines (7).

6. Système de batterie (1) selon la revendication 5,
**caractérisé en ce que** la ligne de mesure (4) est constituée de cuivre et revêtue d'une couche d'isolation électrique.

7. Système de batterie (1) selon la revendication 5,
**caractérisé en ce que** la ligne de mesure (4) peut être reliée à une unité électronique (5) au moyen d'une autre borne guillotine.
